# EUROPEAN PATENT APPLICATION

(11) **EP 4 492 473 A1**
(43) Date of publication of application: **15.01.2025**
(21) Application number: 23887341.8
(22) Date of filing: 31.03.2023
(51) Int. Cl.: H01L 29/78, H01L 29/06, H01L 29/423, H01L 21/336

(54) **SILICON CARBIDE PLANAR MOSFET DEVICE AND MANUFACTURING METHOD THEREFOR**

(30) Priority: 09.11.2022 CN 202211400274
(71) Applicant: United Nova Technology -Yuezhou (Shaoxing) Corp., Shaoxing, Zhejiang 312000 (CN)
(72) Inventor: MA, Yue, Shaoxing, Zhejiang 312000 (CN); HE, Yun, Shaoxing, Zhejiang 312000 (CN)
(74) Representative: Kraus & Lederer PartGmbB
(86) International application number: PCT/CN2023/085347
(87) International publication number: WO 2024/098637

(57) **Abstract**

The present invention provides a planar silicon carbide (SiC) metal oxide semiconductor field effect transistor (MOSFET) device and a manufacturing method therefor. Some shallow trenches are arranged based on that a channel current is still parallel to a (0001) crystal plane of a SiC crystal, to further effectively use a crystal plane having a high channel mobility, for example, a (1120) crystal plane, a (1100) crystal plane, or a (0338) crystal plane, of the SiC crystal, thereby effectively reducing channel resistance of the planar SiC MOSFET device. In addition, source regions, well regions, and a channel are formed without protection from an additional ion implanted layer (IMP layer), leading to simple processes.

## Description

### TECHNICAL FIELD

The present invention relates to the field of semiconductor devices and manufacturing technologies therefor, and in particular, to a planar silicon carbide (SiC) metal oxide semiconductor field effect transistor (MOSFET) device and a manufacturing method therefor.

### BACKGROUND

A SiC MOSFET device has advantages such as a high switching speed and low onresistance, and can achieve a high breakdown voltage level with a smaller drift layer thickness, thereby reducing a volume of a power switch module and reducing energy consumption. The MOSFET device has significant advantages in application fields such as power switches and converters.

Planar SiC MOSFET devices are widely used due to advantages such as simple processes, good cell consistency, and high avalanche energy. However, how to further improve performance of the planar SiC MOSFET device has also become one of the hotspot problems that have been studied by persons skilled in the art.

### SUMMARY

An objective of the present invention is to provide a planar SiC MOSFET device and a manufacturing method therefor, to improve performance of a planar SiC MOSFET device.

To achieve the foregoing objective, the present invention provides a planar SiC MOSFET device. The planar SiC MOSFET device includes:
a SiC drift layer of a first conductivity type, of which a top surface is a (0001) crystal plane;
a gate oxide layer and a gate, sequentially stacked on the top surface of the SiC drift layer;
well regions of a second conductivity type and source regions of the first conductivity type, where the well regions are formed on a surface layer of the SiC drift layer on two sides of the gate, and the source regions are formed in surface layers of the well regions on the two sides of the gate; and
at least one trench, formed in the SiC drift layer at a bottom of the gate, and extending along the two sides of the gate to between boundaries of the source regions and boundaries of the well regions, a bottom of the trench is shallower than bottoms of the well regions, and surfaces of two sidewalls of the trench extending in a width direction of the gate are each a crystal plane having a channel mobility higher than that of the (0001) crystal plane, where
the gate oxide layer covers at least an inner surface of the trench, and the gate buries the trench therein.

Optionally, the crystal plane having the channel mobility higher than that of the (0001) crystal plane includes a (1120) crystal plane, a (1100) crystal plane, or a (0338) crystal plane.

Optionally, a plurality of trenches are sequentially arranged side by side and spaced apart in a length direction of the gate, and any two of the trenches are not in communication or at least two of the trenches are in communication in a corresponding region.

Optionally, a bottom depth of the trench is smaller than bottom depths of the source regions.

Optionally, the planar SiC MOSFET device further includes a dielectric structure, where the dielectric structure is formed in a partial region of the trench, the gate oxide layer covers the inner surface of the trench at a periphery of the dielectric structure, and the gate further buries the dielectric structure therein.

Optionally, a top of the dielectric structure is higher than a top of the gate oxide layer at a periphery of the trench, and the gate conformally covers the dielectric structure to form a protruding portion, or the gate has a flat top.

Optionally, the planar SiC MOSFET device further includes:
sources, formed on the (0001) crystal plane of the SiC drift layer on the two sides of the gate and electrically connected to the source regions;
a buffer layer of the first conductivity type, stacked on a bottom surface of the SiC drift layer;
a base of the first conductivity type, stacked on a bottom surface of the buffer layer; and
a drain, stacked on a bottom surface of the base.

Based on the same inventive concept, the present invention further provides a manufacturing method for the planar SiC MOSFET device according to the present invention. The manufacturing method includes:
providing a substrate including a SiC drift layer of a first conductivity type, where a top surface of the SiC drift layer is a (0001) crystal plane;
etching the top surface of the SiC drift layer in a region of a to-be-formed gate, to form at least one trench, where the trench extends along two sides of the to-be-formed gate to between boundaries of source regions and boundaries of well regions, a bottom of the trench is shallower than bottoms of the well regions, and surfaces of two sidewalls of the trench extending in a width direction of the to-be-formed gate are each a crystal plane having a channel mobility higher than that of the (0001) crystal plane; and
forming a gate oxide layer and a gate sequentially on the top surface of the SiC drift layer, where the gate oxide layer covers at least an inner surface of the trench, and the gate buries the trench therein.

Optionally, before the top surface of the SiC drift layer in the region of the to-be-formed gate is etched, to form the at least one trench, the well regions of the second conductivity type and the source regions of the first conductivity type are first formed in the top surface of the SiC drift layer, the well regions are formed in a surface layer of the top surface of the SiC drift layer on two sides of the gate, and the source regions are formed in surface layers of the well regions on the two sides of the gate; or
after the at least one trench is formed and before or after the gate is formed, the well regions and the source regions are formed in the top surface of the SiC drift layer.

Optionally, the substrate further includes a buffer layer of the first conductivity type and a base of the first conductivity type sequentially stacked on a bottom surface of the SiC drift layer, and the manufacturing method further includes:
forming sources on the top surface of the SiC drift layer, where the sources are electrically connected to the source regions; and
forming a drain on a bottom surface of the base.

Compared with the related art, the technical solutions of the present invention have at least one of the following beneficial effects:
1. It is still ensured that the device is a planar SiC MOSFET device, to mainly use a (0001) crystal plane of a SiC crystal as a channel. A channel current is still parallel to the (0001) crystal plane of the SiC crystal, based on which some shallow trenches are arranged, to further effectively use a crystal plane having a high channel mobility, for example, a (1120) crystal plane, a (1100) crystal plane, or a (0338) crystal plane, of the SiC crystal, thereby effectively reducing channel resistance of the planar SiC MOSFET device.
2. A bottom depth of the trench is shallower than bottom depths of the source regions or well regions, so that protection from an additional ion implanted layer (IMP layer) is not needed, leading to simple processes.
3. A degree by which channel resistance Ron or Rsp is reduced is related to density of trenches, and a planar MOSFET device used below 1700 V has beneficial effects that are more significant. For example, when the solutions of the present invention are applied to a 750 V planar SiC MOSFET device, channel resistance Ron or Rsp may be reduced by 30%.

### BRIEF DESCRIPTION OF THE DRAWINGS

It will be understood by persons of ordinary skill in the art that the accompanying drawings are provided for better understanding of the present invention and do not constitute any limitation to the scope of the present invention, wherein:
FIG. 1 is a schematic top structural view of an existing planar SiC MOSFET device;
FIG. 2 is a schematic cross-sectional structural view along a line AA' in FIG. 1;
FIG. 3 is a schematic diagram of crystal planes of a SiC crystal;
FIG. 4 is a schematic diagram of channel mobility-gate voltage relationship curves of different crystal planes of a SiC crystal;
FIG. 5 is a schematic top structural view of a planar SiC MOSFET device according to an embodiment of the present invention;
FIG. 6 is a schematic cross-sectional structural view along a line AA' in FIG. 5;
FIG. 7 is a schematic cross-sectional structural view along a line BB' in FIG. 5;
FIG. 8 is a schematic cross-sectional structural view along a line CC' in FIG. 5;
FIG. 9 is a schematic cross-sectional structural view of a planar SiC MOSFET device according to another embodiment of the present invention;
FIG. 10 is a schematic cross-sectional structural view of a planar SiC MOSFET device according to still another embodiment of the present invention;
FIG. 11 is a schematic top structural view of a trench in a planar SiC MOSFET device according to yet another embodiment of the present invention;
FIG. 12 and FIG. 13 are schematic cross-sectional structural views of a multi-step trench of a planar SiC MOSFET device according to another embodiments of the present invention;
FIG. 14 is a schematic flowchart of a manufacturing method for a planar SiC MOSFET device according to a specific embodiment of the present invention; and
FIG. 15 is a schematic cross-sectional structural view of a device in a manufacturing method for a planar SiC MOSFET device according to a specific embodiment of the present invention.

### DETAILED DESCRIPTION

In the following description, numerous specific details are given to facilitate a more thorough understanding of the present invention. However, it is obvious to persons skilled in the art that the present invention can be implemented without one or more of these details. In other examples, to avoid confusion with the present invention, some technical features known in the art are not described It should be understood that the present invention can be implemented in different forms and should not be construed as being limited to the embodiments presented herein. Conversely, these embodiments are provided for the purpose of making the disclosure thorough and complete, and conveying the scope of the present invention fully to persons skilled in the art. In the drawings, for the sake of clarity, the sizes and relative sizes of layers and regions may be exaggerated, and the same reference numerals denote the same elements throughout the present invention. It should be understood that when an element or layer is referred to as being "on" or "connected to" other elements or layers, it can be directly located on or connected to the other elements or layers, or there may be an intervening element or layer. Conversely, when an element is referred to as being "directly on" or "directly connected to" other elements or layers, no intervening element or layer is present. Although the terms, such as first and second, can be used to describe various elements, components, regions, layers, and/or portions, these elements, components, regions, layers, and/or portions should not be limited by these terms. These terms are only used to distinguish one element, component, region, layer, or portion from another element, component, region, layer, or portion. Therefore, without departing from the teachings of the present invention, the first element, component, region, layer, or portion discussed below may be expressed as a second element, component, region, layer, or portion. Terms indicating the spatial relationships, such as "under ...", "below", "lower", "above ...", "upper", "on a top surface", "on a bottom surface", "on a front surface", and "on a back surface", are used herein for the convenience of description, to describe the relationship between one element or feature and another element or feature shown in the figure. It can be understood that in addition to the orientations shown in the figures, the terms indicating the spatial relationships are also intended to include different orientations of a device in use and operation. For example, if the device in the figure is upside down, then an element or feature described as being "under ...", "below", "lower", "on a bottom surface", or "on a back surface" will be oriented to be "above", "on the top of", or "on the front of" another element or feature. The device can be otherwise oriented (rotated by 90 degrees or in other orientations), and the spatial descriptive terms used herein are interpreted accordingly. The terms are used herein merely for purpose of describing specific embodiments and not as a limitation of the present invention. When used herein, the singular forms "a", "an", and "the" are also meant to include the plural form, unless otherwise clearly indicated. It should also be understood that the term "include" is used to confirm the existence of the features, steps, operations, elements, and/or components, but do not exclude the existence or addition of one or more other features, steps, operations, elements, components, and/or groups. As used herein, the term "and/or" includes any and all combinations of related listed items.

The technical solutions provided in the present invention are further described below in detail with reference to the accompanying drawings and specific embodiments. The advantages and features of the present invention are more clearly according to the following descriptions. It should be noted that the accompanying drawings are all in a very simplified form and are not drawn to accurate scale, but are merely used for convenience and clarity of description of the embodiments of the present invention.

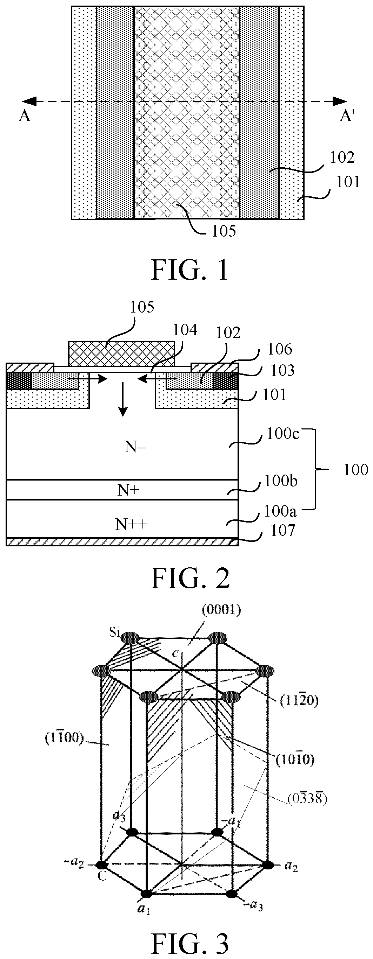

Referring to FIG. 1 and FIG. 2, a structure of an existing planar SiC MOSFET device includes a drain 107, an N++ base 100a, an N+ buffer layer 100b, an N- drift layer 100c, a gate oxide layer 104, and a gate 105 sequentially stacked from bottom to top, and further includes P wells 101 formed in the N- drift layer 100c, N+ source regions 102 and P+ contact regions 103 that are formed in the P wells 101 (also referred to as Pbase regions), and metal layers of the sources 106 formed on the N- drift layer 100c. The sources 106 are in electrical contact with the N+ source regions 102 and the P+ contact regions 103 to short-circuit the N+ source regions 102 and the P+ contact regions 103.

In the foregoing planar SiC MOSFET device, a channel (not marked) is located in a region in which a bottom of the gate 105 overlaps the P wells 101. During forward operation, when a gate voltage is positively biased and greater than a threshold thereof, an inversion layer is formed, the channel is opened, and electrons flow from the sources 106, through the N+ source regions 102 and the channel in sequence, to reach a depletion region (also referred to as a JFET region, that is, the N- drift layer 100c located below the bottom of the gate 105 and between the two P wells 101), and flow downward through the N- drift layer 100c, the N+ buffer layer 100b, and the N++ base 100a, to finally reach a metal layer of the drain 107. When the gate 105 and the sources 106 are short-circuited, and the drain 107 is positively biased, the P wells 101 and the N- drift layer 100c form a reverse-biased depletion region, and since P-type ion doping concentrations of the P wells 101 are greater than an N-type ion doping concentration of the N- drift layer 100c, the reverse-biased depletion region mainly expands toward the N-drift layer 100c to reach a high breakdown voltage.

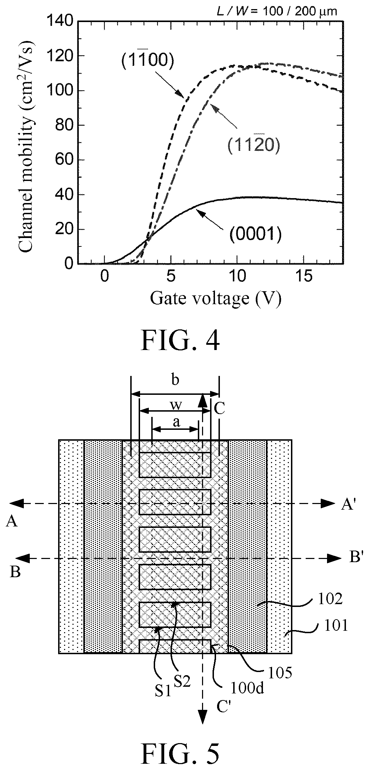

However, the foregoing planar SiC MOSFET device has some defects. Specifically, an existing planar SiC MOSFET device is usually manufactured by using a 4H-SiC crystal. A distribution diagram of crystal planes and crystal directions of the 4H-SiC crystal is shown in FIG. 3. Due to influence of a 4H-SiC epitaxial (EPI) crystal direction, the gate 105 of the planar SiC MOSFET device is always located on the (0001) crystal plane of the SiC crystal. However, the (0001) crystal plane has a large number of interface states, and has a channel mobility of only 1/3 of that of the (1120) crystal plane and that of the (1100) crystal plane, as shown in FIG. 4. Therefore, the planar SiC MOSFET device has high channel resistance. In addition, parasitic capacitance of such a structure is also large. The (1120) crystal plane and the (1100) crystal plane are facets perpendicular to the (0001) crystal plane.

In addition, in the related art, there are few wafers that are expitaxially grown on a crystal plane having a high channel mobility, such as the (1120) crystal plane, the (1100) crystal plane, or the (0338) crystal plane, of the SiC crystal. Moreover, even if a wafer can be expitaxially grown on a crystal plane having a high channel mobility, such as the (1120) crystal plane, the (1100) crystal plane, or the (0338) crystal plane, of the SiC crystal, an epitaxial defect directly extends to the entire surface of the wafer, resulting in large power leakage and poor electrical performance of a manufactured device.

Therefore, the present invention provides a novel structural design and manufacturing method for a planar SiC MOSFET device, so that based on that a gate is located on a (0001) crystal plane of a SiC crystal, another crystal plane having a high channel mobility of the SiC crystal, for example, a crystal planes having a high channel mobility, such as a (1120) crystal plane, a (1100) crystal plane, and a (0338) crystal plane, can be further effectively used to reduce channel resistance and improve performance of a device. In addition, parasitic capacitance of the device is further reduced.

Referring to FIG. 5 to FIG. 8, an embodiment of the present invention provides a planar SiC MOSFET device. The planar SiC MOSFET device includes a drain 107, a base 100a, a buffer layer 100b, a SiC drift layer 100c, a gate oxide layer 104, and a gate 105 sequentially stacked from bottom to top (that is, from a bottom surface to a top surface).

The base 100a, the buffer layer 100b, and the SiC drift layer 100c are all of a first conductivity type (for example, an N-type), and their impurity doping concentrations of the first conductivity type decrease in sequence.

A SiC crystal in the SiC drift layer 100c is a hexagonal crystal such as a 4H-SiC crystal or a 6H-SiC crystal. A top surface (which may also be referred to as a front surface) of the SiC drift layer 100c is a (0001) crystal plane of the SiC crystal. In addition, well regions 101 of a second conductivity type (for example, a P-type) are formed in a surface layer of the top surface of the SiC drift layer 100c on two sides of the gate 105, a source region 102 of the first conductivity type is formed in a surface layer of a top surface of the well region 101 on each side, and body contact regions 103 of the second conductivity type are formed in the well regions 101 at peripheries of the source regions 102. Impurity doping concentrations of the first conductivity type in the source regions 102 and impurity doping concentrations of the second conductivity type in the body contact regions 103 are respectively greater than impurity doping concentrations of the second conductivity type in the well regions 101.

Source 106 are formed on surfaces of the source regions 102 and the body contact regions 103, and are electrically connected the body contact regions 103 and the source regions 102, to make them have an equal potential. The drain 107 is stacked on a bottom surface of the base 100a (that is, a back surface of the base 100a). The sources 106 and the drain 107 may both be mainly made of metal, and materials thereof may be selected from one of Al, AlCu, or AlSiCu.

In this embodiment, the gate 105, the source regions 102, and the well regions 101 are all arranged as strip-shaped structures parallel to each other. A material of the gate 105 may include doped polysilicon, and a conductivity type of the gate 105 may be opposite to that of the SiC drift layer 100c.

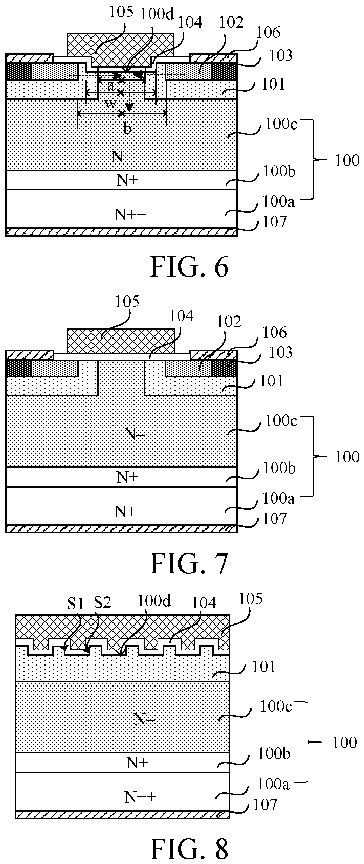

At least one trench 100d is arranged in the SiC drift layer 100c below a bottom of the gate 105. The at least one trench 100d is arranged in a channel current crossing direction (as indicated by a dashed arrow in FIG. 6), and when there are a plurality of trenches 100d, the trenches 100d are formed spaced apart in the channel current crossing direction (as indicated by the dashed arrow in FIG. 6). Bottoms of all the trenches 100d are shallower than bottoms of the well regions 101. Optionally, bottoms of all the trenches 100d are shallower than bottoms of the source regions 102. For example, bottom depths (that is, heights from the top surface of the SiC drift layer to bottom surfaces of the trenches 100d) of all the trenches 100d are less than 1000 Å.

The trenches 100d may be in any suitable shape, for example, a cuboid or a trapezoid. Each trench 100d extends along two sides of the gate 105 to between boundaries of the source regions 102 and boundaries of the well regions 101. To be specific, a length w by which the trench 100d extends in a width direction (namely, a direction AA' or a direction BB' in FIG. 5) of the gate is between a distance a between the well regions 101 on the two sides of the gate 105 and a distance b between the source regions 102, that is, a<w<b.

Crystal planes of two sidewall surfaces S1 and S2 of each trench 100d extending in the width direction of the gate 105 are each a crystal plane having a channel mobility higher than that of the (0001) crystal plane in the SiC crystal, for example, a (1120) crystal plane, a (1100) crystal plane, or a (0338) crystal plane of the SiC crystal. That is, the sidewall surfaces S1 and S2 are parallel to the (1120) crystal plane, the (1100) crystal plane, or the (0338) crystal plane of the SiC crystal in the SiC drift layer 100c. Referring to FIG. 3, both the (1120) crystal plane and the (1100) crystal plane of the SiC crystal are facets perpendicular to the (0001) crystal plane of the SiC crystal, and a channel mobility of the (1120) crystal plane or the (1100) crystal plane is about 3 times that of the (0001) crystal plane. The (0338) crystal plane of the SiC crystal is a crystal plane at an angle of about 55° or 54.74° to a (1010) crystal plane of the SiC crystal. The (0001) crystal plane of the SiC crystal is parallel to the (1010) crystal plane of the SiC crystal.

It should be understood that the two sidewall surfaces S1 and S2 of each trench 100d may be parallel to the width direction AA' of the gate, or intersect, due to a process error, the width direction AA' of the gate, however, at an angle limited within an allowable range. In other words, angles between the two sidewall surfaces S1 and S2 of the trench 100d and the direction AA' may not be 90° provided that it is ensured that crystal planes of the sidewall surfaces S1 and S2 are each a crystal plane having a high channel mobility such as the (1120) crystal plane, the (1100) crystal plane, or the (0338) crystal plane.

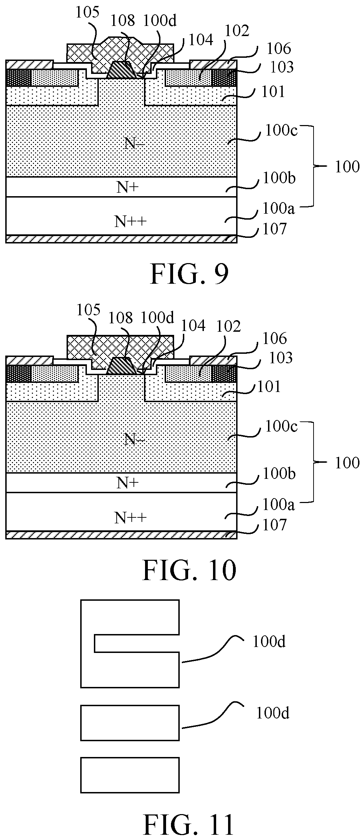

Optionally, in other embodiments of the present invention, to reduce parasitic capacitance of the gate 105, referring to FIG. 9, the planar SiC MOSFET device further includes a dielectric structure 108. The dielectric structure 108 is formed in a partial region of the trench 100d and is configured to raise the bottom of the gate 105. The gate oxide layer 104 covers an inner surface of the trench 100d at a periphery of the dielectric structure 108 and exposed surfaces of the source regions 102. The gate 105 further buries the dielectric structure 108 therein. The dielectric structure 108 is made of an insulating dielectric material, and a material thereof is selected from one or more of silicon oxide, silicon nitride, silicon oxynitride, aluminum oxide, a high-K material, a spin-on dielectric material (for example, spin-on phosphosilicate glass, borophosphosilicate glass, or fluorosilicate glass), or a dielectric material having a low dielectric constant. By arranging the foregoing dielectric structure 108, a distance between the gate 105 and the drain 107 is increased, which is equivalent to directly increasing a distance between two electrodes of gate-drain capacitance (Cgd), so that Cgd, that is, reverse transmission capacitance or Miller capacitance, can be effectively reduced, and application losses can be reduced. For example, a top of the dielectric structure 108 is higher than a top of the gate oxide layer 104 at the periphery of the trench 100d, and the gate 105 conformally covers the dielectric structure 108 and the gate oxide layer 104, to form a protruding portion (not marked), as shown in FIG. 9. In another example, a top of the dielectric structure 108 is higher than a top of the gate oxide layer 104 at the periphery of the trench 100d. The gate 105 further buries the dielectric structure 108 therein, and the gate 105 has a flat top, as shown in FIG. 10.

Referring to FIG. 5 to FIG. 10, in the foregoing embodiments, the plurality of trenches 100d formed may be sequentially arranged side by side and spaced apart at an equal distance or different distances in a length direction of the gate 105. Any two trenches 100d are not in communication with each other. In this case, the plurality of trenches 100d are formed spaced apart in the channel current crossing direction. However, the technical solutions of the present invention are not limited thereto. In other embodiments of the present invention, referring to FIG. 11, the plurality of trenches 100d may be sequentially arranged side by side and spaced a part in a length direction of the gate 105, and at least two of the trenches 100d are in communication with each other in a corresponding region (for example, an end portion or an intermediate segment). The trenches 100d in communication may be adjacent, or may be further separated by at least one trench 100d.

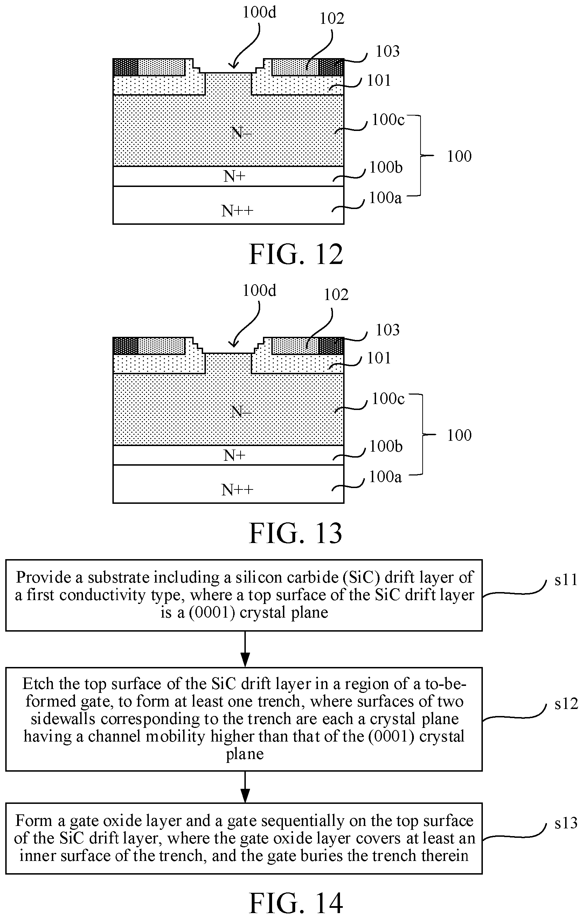

With further reference to FIG. 5 to FIG. 10, in the foregoing embodiments, the trenches 100d formed are each a single-step trench, but the technical solutions of the present invention are not limited thereto. In other embodiments of the present invention, at least one trench 100d may be a two-step trench, a three-step trench, or trench with more steps as long as allowed by the overall depth design of the trench 100d. A cross-sectional structure of the trench 100d presented as a two-step trench is shown in FIG. 12. Sidewall surfaces including S1 and S2 of the trench 100d may each have two steps. A cross-sectional structure of the trench 100d presented as a three-step trench is shown in FIG. 13. Sidewall surfaces including S1 and S2 of the trench 100d may each have three steps.

Based on the same inventive concept, referring to FIG. 14, an embodiment of the present invention further provides a manufacturing method for a planar SiC MOSFET device, so that the planar SiC MOSFET device of the present invention can be manufactured. The manufacturing method specifically includes the following steps:
s11: Provide a substrate including a SiC drift layer of a first conductivity type, where a top surface of the SiC drift layer is a (0001) crystal plane.
s12: Etch the top surface of the SiC drift layer in a region of a to-be-formed gate, to form at least one trench, where the trench extends along two sides of the to-be-formed gate to between boundaries of source regions and boundaries of well regions, a bottom of the trench is shallower than bottoms of the well regions, and surfaces of two sidewalls of the trench extending in a width direction of the to-be-formed gate are each a crystal plane having a channel mobility higher than that of the (0001) crystal plane.
s13: Form a gate oxide layer and a gate sequentially on the top surface of the SiC drift layer, where the gate oxide layer covers at least an inner surface of the trench, and the gate buries the trench therein.

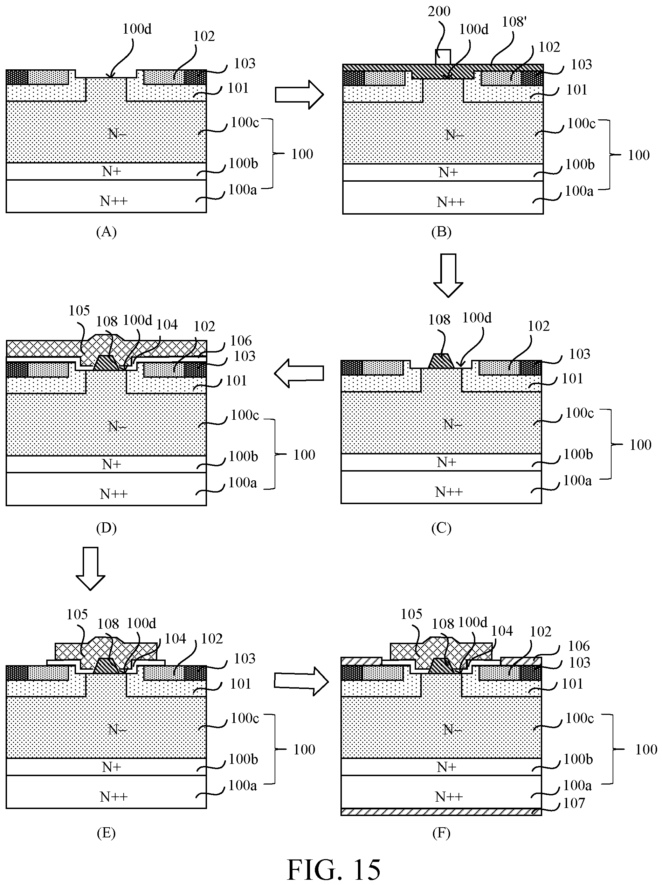

In step s11, referring to (A) in FIG. 15, a base 100a is provided, and a buffer layer 100b of a first conductivity type and a SiC drift layer 100c are sequentially formed on the base 100a through any suitable process such as an epitaxial growth process. A top surface of the SiC drift layer 100c is a (0001) crystal plane. Thicknesses and doping concentrations of the base 100a, the buffer layer 100b, and the SiC drift layer 100c are all designed according to requirements of the device, and are not specifically limited in this embodiment.

In step s12, referring to (A) in FIG. 15, first, dry etching is performed on a surface layer of a region in which a channel and a depletion layer are to be formed in the SiC drift layer 100c, to form the at least one trench 100d. The surfaces of the two sidewalls of the trench 100d extending in the width direction of the to-be-formed gate are each a crystal plane having a channel mobility higher than that of the (0001) crystal plane.

Optionally, a crystal plane of the trench 100d may be trimmed through an appropriate process such as wet etching or oxidation followed by wet etching, to form a crystal plane having a high channel mobility such as a (1120) crystal plane, a (1100) crystal plane, or a (0338) crystal plane, or the trench 100d may be trimmed from a single-step trench to a two-step trench shown in FIG. 12, a three-step trench shown in FIG. 13, or a trench with more steps.

In an example of this embodiment, referring to (A) in FIG. 15, before step s12 is performed, that is, before the top surface of the SiC drift layer 100c in the region of the to-be-formed gate is etched, to form the at least one trench 100d, well regions 101 of a second conductivity type are first formed in the top surface of the SiC drift layer 110c through a series of processes such as mask deposition, patterning, and ion implantation, and then, source regions 102 of the first conductivity type and body contact regions 103 of the second conductivity type are formed, where the formed trench 100d extends from the well region 101 on one side serving as a boundary region of a channel to the well region 101 on the other side serving as a boundary region of the channel. The source regions 102 are formed in surface layers of the well regions 101 on the two sides respectively, and there are gaps between the trench 100d and boundaries of the source regions 102. To be specific, as shown in FIG. 5 and FIG. 6, a length w by which the trench 100d extends in a width direction (namely, a direction AA' or a direction BB' in FIG. 5) of the gate is between a distance a between the well regions 101 on the two sides of the gate 105 and a distance b between the source regions 102, that is, a<w<b. Further, after the well regions 101, the source regions 102, and the body contact regions 103 are formed, the corresponding mask is removed, and implanted impurities are activated through a high-temperature annealing process. A bottom depth of the trench 100d is shallower than bottom depths of the source regions 102 or bottom depths of the well regions 101.

In another example of this embodiment, referring to (A) in FIG. 15, after step s12 is performed, well regions 101 are first formed in the top surface of the SiC drift layer 100c on two sides of the trench 100d through a series of processes such as mask deposition, patterning, and ion implantation, and then, source regions 102 of the first conductivity type and body contact regions 103 of the second conductivity type are formed. After the well regions 101, the source regions 102, and the body contact regions 103 are formed, the corresponding mask is removed, and implanted impurities are activated through a high-temperature annealing process. A bottom depth of the trench 100d is shallower than bottom depths of the source regions 102 or bottom depths of the well regions 101. Each trench 100d extends along two sides of the gate 105 to between boundaries of the source regions 102 and boundaries of the well regions 101. To be specific, as shown in FIG. 5 and FIG. 6, a length w by which the trench 100d extends in a width direction (namely, a direction AA' or a direction BB' in FIG. 5) of the gate is between a distance a between the well regions 101 on the two sides of the gate 105 and a distance b between the source regions 102, that is, a<w<b.

In step s13, referring to (D) and (E) in FIG. 15, a gate oxide layer 104 may be formed through a thermal oxidation process, a deposition process, or the like. Polysilicon is deposited on the gate oxide layer 104, and impurities of the second conductivity type are implanted and activated to form a highly-doped polysilicon gate material layer. Then, the polysilicon gate material layer and the gate oxide layer 104 are patterned to form the gate 105 and the gate oxide layer 104 covered by the gate 105.

In an example of this embodiment, referring to (B) and (C) in FIG. 15, after step s12 is performed and before step s13, a dielectric layer 108' is first covered on the trench 100d, the source regions 102, and the body contact regions 103 through an appropriate process such as deposition or spin coating. The dielectric layer 108' may have a flat top surface or an uneven top surface. A top height of the dielectric layer 108' protrudes above the top surface of the SiC drift layer 100c. Then, a patterned mask 200 is formed through processes such as photoresist coating, exposure, and development. Further, under a masking effect of the patterned mask 200, the dielectric layer 108' is etched to form the dielectric structure 108 in the trench 100d. The gate 105 formed in step s13 may conformally cover the dielectric structure 108 and the gate oxide layer 104. The gate 105 may have a flat top surface or a convex top surface.

It should be noted that for formation of the source regions, the well regions, and the channels, compared to the related art, protection from an additional ion implanted layer (IMP layer) is not needed for formation of the trench 100d. Therefore, the manufacturing method of this embodiment has simple processes, and is easy to implement.

Further, referring to (E) and (F) in FIG. 15, after step s 13 is performed, a passivation layer (not shown) may be deposited on the gate 105 and a surface of the device exposed by the gate 105, and the passivation layer is etched to form a surface that exposes the source regions 102 and the body contact regions 103. Further, a source metal is grown on the source regions 102 and the body contact regions 103, and is annealed to form sources 106. The sources 106 are electrically connected to the source regions 102 and the body contact regions 103. Next, a drain metal is deposited on a bottom surface of the base 100a, and is annealed to form a drain 107.

In conclusion, in the planar SiC MOSFET device and the manufacturing method therefor in the present invention, some shallow trenches are arranged based on that a channel current is still parallel to a (0001) crystal plane of a SiC crystal, to further effectively use a crystal plane having a high channel mobility, for example, a (1120) crystal plane, a (1100) crystal plane, or a (0338) crystal plane, of the SiC crystal, thereby effectively reducing channel resistance of the planar SiC MOSFET device. In addition, source regions, well regions, and a channel are formed without protection from an additional ion implanted layer (IMP layer), leading to simple processes. Besides, a degree by which channel resistance Ron or Rsp is reduced is related to density of trenches, and a planar MOSFET device used below 1700 V has beneficial effects that are more significant. For example, when the solutions of the present invention are applied to a 750 V planar SiC MOSFET device, channel resistance Ron or Rsp may be reduced by 30%.

The foregoing descriptions are merely descriptions of the preferred embodiments of the present invention and do not limit the scope of the present invention in any way. All changes or modifications made by persons of ordinary skill in the art of the present invention according to the foregoing disclosure fall within the protection scope of the technical solutions of the present invention.

## Claims

1. A planar silicon carbide (SiC) metal oxide semiconductor field effect transistor (MOSFET) device, comprising:
a SiC drift layer of a first conductivity type, of which a top surface is a (0001) crystal plane;
a gate oxide layer and a gate, sequentially stacked on the top surface of the SiC drift layer;
well regions of a second conductivity type and source regions of the first conductivity type, wherein the well regions are formed on a surface layer of the SiC drift layer on two sides of the gate, and the source regions are formed in surface layers of the well regions on the two sides of the gate; and
at least one trench, formed in the SiC drift layer at a bottom of the gate, and extending along the two sides of the gate to between boundaries of the source regions and boundaries of the well regions, a bottom of the trench is shallower than bottoms of the well regions, and surfaces of two sidewalls of the trench extending in a width direction of the gate are each a crystal plane having a channel mobility higher than that of the (0001) crystal plane, wherein
the gate oxide layer covers at least an inner surface of the trench, and the gate buries the trench therein.

2. The planar SiC MOSFET device according to claim 1, wherein the crystal plane having a channel mobility higher than that of the (0001) crystal plane comprises a (1120) crystal plane, a (1100) crystal plane, or a (0338) crystal plane.

3. The planar SiC MOSFET device according to claim 1, wherein a plurality of trenches are sequentially arranged side by side and spaced apart in a length direction of the gate, and any two of the trenches are not in communication or at least two of the trenches are in communication in a corresponding region.

4. The planar SiC MOSFET device according to claim 1, wherein a bottom depth of the trench is smaller than bottom depths of the source regions.

5. The planar SiC MOSFET device according to claim 1, further comprising a dielectric structure, wherein the dielectric structure is formed in a partial region of the trench, the gate oxide layer covers the inner surface of the trench at a periphery of the dielectric structure, and the gate further buries the dielectric structure therein.

6. The planar SiC MOSFET device according to claim 7, wherein a top of the dielectric structure is higher than a top of the gate oxide layer at a periphery of the trench, and the gate conformally covers the dielectric structure to form a protruding portion, or the gate has a flat top.

7. The planar SiC MOSFET device according to any one of claims 1 to 8, further comprising:
sources, formed on the (0001) crystal plane of the SiC drift layer on the two sides of the gate and electrically connected to the source regions;
a buffer layer of the first conductivity type, stacked on a bottom surface of the SiC drift layer;
a base of the first conductivity type, stacked on a bottom surface of the buffer layer; and
a drain, stacked on a bottom surface of the base.

8. A manufacturing method for the planar silicon carbide (SiC) metal oxide semiconductor field effect transistor (MOSFET) according to any one of claims 1 to 7, comprising:
providing a substrate comprising a SiC drift layer of a first conductivity type, wherein a top surface of the SiC drift layer is a (0001) crystal plane;
etching the top surface of the SiC drift layer in a region of a to-be-formed gate, to form at least one trench, wherein the trench extends along two sides of the to-be-formed gate to between boundaries of source regions and boundaries of well regions, wherein a bottom of the trench is shallower than bottoms of the well regions, and surfaces of two sidewalls of the trench extending in a width direction of the to-be-formed gate are each a crystal plane having a channel mobility higher than that of the (0001) crystal plane; and
forming a gate oxide layer and a gate sequentially on the top surface of the SiC drift layer, wherein the gate oxide layer covers at least an inner surface of the trench, and the gate buries the trench therein.

9. The manufacturing method according to claim 8, wherein before the top surface of the SiC drift layer in the region of the to-be-formed gate is etched, to form the at least one trench, the well regions of the second conductivity type and the source regions of the first conductivity type are first formed in the top surface of the SiC drift layer, the well regions are formed in a surface layer of the top surface of the SiC drift layer on two sides of the gate, and the source regions are formed in surface layers of the well regions on the two sides of the gate; or
after the at least one trench is formed and before or after the gate is formed, the well regions and the source regions are formed in the top surface of the SiC drift layer.

10. The manufacturing method according to claim 8 or 9, wherein the substrate further comprises a buffer layer of the first conductivity type and a base of the first conductivity type sequentially stacked on a bottom surface of the SiC drift layer, and the manufacturing method further comprises:
forming sources on the top surface of the SiC drift layer, wherein the sources are electrically connected to the source regions; and
forming a drain on a bottom surface of the base.
